# EUROPÄISCHE PATENTANMELDUNG

(11) **EP 0 994 644 A1**
(43) Veröffentlichungstag der Anmeldung: **19.04.2000**
(21) Anmeldenummer: 98119343.6
(22) Anmeldetag: 14.10.1998
(51) Int. Cl.: H05K 7/18, H05K 7/14

(54) **Bauelementesatz zur Verkleidung eines Baugruppenträgers**

(71) Anmelder: Schroff GmbH, D-75334 Straubenhardt (DE)
(72) Erfinder: Guiol, Eric, D-76316, Malsch (DE)
(74) Vertreter: Durm, Klaus, Dr.-Ing.

(57) **Zusammenfassung**

Ein normgerechter Baugruppenträger der Industrieelektronik soll auf einfache Weise zu einem stabilen und formschönen Gehäuse ausgebaut werden. Hierzu dient ein Bauelementesatz, bestehend aus einer untersetzbaren Bodenplatte 4, zwei ansetzbaren Seitenteilen 5, einer aufsetzbaren Deckplatte 6 sowie einer zwischen die Seitenteile 5 einsetzbaren Rückwand 7. Die Seitenteile 5 weisen an ihren Vorderkanten nach innen abgewinkelte Halteleisten 9 auf, welche die Befestigungsflansche 2 des Baugruppenträgers 1 umgreifen. Gewindebolzen 8 dienen dazu, die Verkleidungsteile miteinander zu verbinden.

## Beschreibung

Die Erfindung betrifft einen Bauelementesatz zur Verkleidung eines Baugruppenträgers, der an seiner Frontseite seitlich überstehende Befestigungsflansche aufweist.

Baugruppenträger sind das wichtigste Modul von Aufbausystemen, insbesondere des bekannten 19-Zoll-Aufbausystems, mit dessen Hilfe elektronische Geräte und Anlagen in modularer Bauweise zusammengesetzt werden können.

Baugruppenträger für das 19-Zoll-Aufbausystem sind üblicherweise als Metallrahmenkonstruktion ausgeführt und weisen an ihrer Frontseite zwei seitliche Flansche auf, die zur Befestigung des Baugruppenträgers in einem Gestell, einem Schrank oder Gehäuse dienen. Zwischen den beiden Flanschen befindet sich ein Freiraum, in den elektronische Baugruppen auf Leiterplatten eingesetzt werden. Näheres über die modulare Aufbautechnik elektronischer Geräte und Anlagen findet sich beispielsweise in: Hesse, Handbuch des 19-Zoll-Aufbausystems, Markt- und Technik-Verlag, 1986.

Mit elektronischen Baugruppen bestückte Baugruppenträger lassen sich mittels ihrer Befestigungsflansche in Schränke und Gehäuse einbauen. Hierzu weisen die Befestigungsflansche je zwei Befestigungsbohrungen auf. Mehrere Baugruppenträger lassen sich übereinander in einem Schrank oder einem entsprechend hohen Gehäuse unterbringen.

Auch ein einzelner Baugruppenträger läßt sich in ein vorgefertigtes Gehäuse einsetzen. Dieses Gehäuse kann beispielsweise als Tischgehäuse, tragbares Gehäuse oder aufrecht stehendes Tower-Gehäuse ausgeführt sein. Von Elektronikschränken unterscheiden sich solche Gehäuse im Prinzip nur durch den wesentlich niedrigeren Einbauraum. Ebenso wie Schränke sind auch Gehäuse, die zur Aufnahme nur eines einzigen Baugruppenträgers vorgesehen sind, als selbsttragende Konstruktion in Blech oder Kunststoff ausgeführt. Sie beinhalten zwei Befestigungsschienen mit entsprechenden Lochungen zur Verschraubung mit den Befestigungsflanschen des Baugruppenträgers. Derartige Gehäuse sind ebenfalls in dem erwähnten Handbuch des 19-Zoll-Aufbausystems, ab Seite 129, beschrieben.

Die herkömmlichen Gehäuse zur Aufnahme eines (einzigen) Baugruppenträgers sind, wie bereits erwähnt, als selbsttragende Konstruktion ausgeführt. Die Gehäusekonstruktion muß zumindest so stabil und verwindungssteif sein, daß sie die Gewichtskraft des komplett bestückten Baugruppenträgers, welche über dessen Befestigungsflansche auf die Seitenwände des Gehäuses übertragen wird, aufnehmen. Es ist klar, daß ein solches selbsttragendes Gehäuse selbst ausreichend stabil und damit schwer ausgeführt sein muß und somit in der Herstellung teuer ist. Außerdem ist es umständlich, einen Baugruppenträger mittels seiner Flansche und (vier) Befestigungsschrauben in ein Gehäuse einzubauen.

Das zu lösende technische Problem besteht also darin, einen Baugruppenträger auf einfache und billige Weise in ein formschönes Gehäuse zu verwandeln.

Ging man bisher immer davon aus, daß die seitlich überstehenden Befestigungsflansche eines Baugruppenträgers für die kraftschlüssige Verbindung mit einem den Baugruppenträger aufnehmenden Gehäuse genutzt werden müssen, so beruht die vorliegende Erfindung auf dem Prinzip, die vorhandene mechanische Stabilität des Baugruppenträgers als tragenden Kern des Gehäuses auszunutzen und lediglich speziell angepaßte Verkleidungsteile anzubauen, um das gewünschte Komplettgerät zu erhalten.

Gelöst wird die Aufgabe durch einen Bauelementesatz gemäß Patentanspruch 1, umfassend eine Bodenplatte, zwei Seitenteile, eine Deckplatte und lösbare Befestigungsmittel.

Mittels des erfindungsgemäß ausgestalteten Bauelementesatzes läßt sich ein normgerechter 19-Zoll-Baugruppenträger schnell, einfach und kostengünstig zu einem formschönen Gerätegehäuse ausbauen. Hierzu wird zunächst der Baugruppenträger auf die untersetzbare Bodenplatte aufgelegt. Anschließend werden die beiden Seitenteile seitlich an den Baugruppenträger angesetzt. Die Seitenteile sind dadurch gekennzeichnet, daß sie an den Vorderkanten nach innen abgewinkelte Halteleisten aufweisen, welche die Befestigungsflansche des Baugruppenträgers umgreifen und diesen dadurch festlegen. Zum Schluß wird die Deckplatte auf den Baugruppenträger und die beiden Seitenteile aufgesetzt. Bodenplatte, Seitenteile und Deckplatte werden durch lösbare Befestigungsmittel miteinander verbunden. Anders als bei den herkömmlichen, vollständig vorgefertigten Gerätegehäusen, in die der Baugruppenträger eingeschraubt wird, gibt es bei dem mittels des erfindungsgemäßen Bauelementesatzes zusammengefügten Gehäuse keine kraftschlüssige Verbindung mit den Befestigungsflanschen des Baugruppenträgers. Vielmehr sorgt die spezielle Ausbildung der Seitenteile mit nach innen abgewinkelten, die Befestigungsflansche umgreifenden Halteleisten dafür, daß der Baugruppenträger seine definierte Lage beibehält.

Die einzelnen Elemente des vorgeschlagenen Bauelementesatzes sind konstruktiv äußerst einfach ausgebildet und lassen sich deshalb sehr kostengünstig herstellen. Die Montage am Baugruppenträger nach dem Baukastenprinzip ist einfach und schnell bewerkstelligt. Ebenso einfach läßt sich das Gehäuse wieder in seine Einzelteile zerlegen, um gegebenenfalls an den "nackten" Baugruppenträger heranzukommen. Da die Halteleisten der Seitenteile lediglich die Befestigungsflansche des Baugruppenträgers umgreifen, nicht jedoch den eigentlichen Frontplattenbereich abdecken, lassen sich auch in den verkleideten Baugruppenträger elektronische Baugruppen einsetzen bzw. aus diesem herausziehen.

Bei Bedarf läßt sich der Bauelementesatz ergänzen durch eine zwischen die Seitenteile einsetzbare Rückwand. Dieser Rückwand bedarf es nicht, sofern der Baugruppenträger selbst bereits an der Rückseite mit einer Abdeckung versehen ist und es dem Benutzer gleichgültig ist, wie die Rückseite seines Gerätes aussieht.

Zweckmäßig sind die Maße von Bodenplatte, Seitenteile und Deckplatte auf die genormten Abmessungen des zu umkleidenden Baugruppenträgers so abgestimmt, daß letzterer unverrückbar festliegt. Insbesondere wird man die Seitenteile geringfügig niedriger ausbilden als die Seitenwände des Baugruppenträgers, so daß nach dem Aufsetzen der Deckplatte der Baugruppenträger zwischen Bodenplatte und Deckplatte Hemmend gehalten wird.

Eine noch höhere mechanische Stabilität läßt sich allerdings dann erreichen, wenn, gemäß einer vorteilhaften Weiterbildung der Erfindung, die beiden Seitenteile an ihren Innenseiten Nuten aufweisen, in welche die Befestigungsflansche des Baugruppenträgers eingreifen. In diesem Falle können die beiden Seitenteile auf die Flansche des Baugruppenträgers aufgesteckt werden.

Vorteilhafterweise tragen die Seitenteile im Bereich ihrer Hinterkanten ferner Haltestege, die gegebenenfalls der Befestigung der Rückwand dienen. Anstelle von Haltestegen können auch Nuten oder andere geeignete Befestigungsmittel für die Rückwand vorgesehen sein.

Besonders bevorzugt wird eine Ausführung, bei der die Seitenwände gleich ausgebildet sind und im wesentlichen U-förmigen Grundriß haben. Dabei bilden die vorderen U-Schenkel die Halteleisten zum Umgreifen der Befestigungsflansche des Baugruppenträgers, während die hinteren U-Schenkel die Haltestege für die Fixierung der Rückwand darstellen.

Die Seitenteile lassen sich am besten als Strangpreßprofil, vorzugsweise in Aluminium oder Kunststoff, ausführen.

Bodenplatte und Deckplatte, die vorzugsweise im wesentlichen eben ausgeführt sind, lassen sich kostengünstig aus Kunststoff herstellen.

Als lösbare Befestigungsmittel kommen zweckmäßigerweise Gewindebolzen zum Einsatz, welche durch die Seitenteile hindurchgeführt sind. Die einzelnen Verkleidungsteile können aber auch miteinander verrastet oder verklammert werden.

Da der vorgeschlagene Bauelementesatz im einfachsten Fall nur aus drei unterschiedlichen Teilen (Bodenplatte, Seitenteile, Deckplatte) besteht, lassen sich sehr leicht unterschiedliche Gehäuseformen verwirklichen. Beispielsweise kann ein Gerätegehäuse mit konkav geschwungener Front realisiert werden. Das Äußere eines elektronischen Gerätes kann so mit relativ wenig Auwand nach Kundenwünschen gestaltet werden, was bei wachsenden Ansprüchen an das Design, auch im Industriebereich, ein großer Vorteil des erfindungsgemäßen Bauelementesatzes ist.

Ein Ausführungsbeispiel der Erfindung wird nachstehend anhand der beigefügten Zeichnungen näher erläutert. Es zeigen:
- Figur 1: einen Baugruppenträger und einen Bauelementesatz zur Verkleidung des Baugruppenträgers, in einem vereinfachten Explosionsbild;
- Figur 2: ein aus dem Baugruppenträger und dem Bauelementesatz von Figur 1 gebildetes Tischgerät;
- Figur 3: die reche Seitenwand des Bauelementesatzes von Figur 1, in einem Schnittbild.

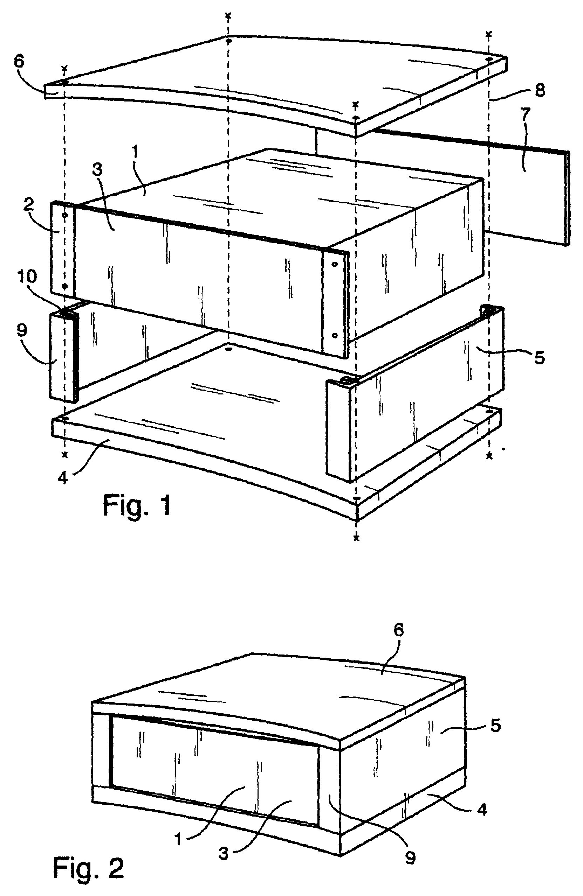

Der in Figur 1 stark vereinfacht dargestellte 19-Zoll-Baugruppenträger 1 trägt an seiner Frontseite die charakteristischen, seitlich überstehenden Befestigungsflansche 2, die normalerweise zum Einschrauben in ein Gestell, Gehäuse oder einen Schrank dienen. Zwischen den Befestigungsflanschen 2 befindet sich das Einbaufeld 3 für elektronische Baugruppen.

Der Bauelementesatz zur vollständigen Verkleidung des Baugruppenträgers 1 umfaßt eine Bodenplatte 4, zwei gleich ausgebildete Seitenteile 5, eine Deckplatte 6, eine Rückwand 7 sowie vier - hier nur angedeutete - Gewindebolzen 8.

Die untersetzbare Bodenplatte 4 ist als ebenes Kunststoff-Formteil ausgeführt. Auf sie wird der zu verkleidende Baugruppenträger 1 einfach aufgelegt.

Die beiden Seitenteile 5 sind als Strangpreßprofil in Aluminium ausgeführt. Jedes Seitenteil 5 hat an seiner Vorderkante eine nach innen abgewinkelte Halteleiste 9, welche den entsprechenden Befestigungsflansch 2 des Baugruppenträgers 1 von der Frontseite her umgreift. Die Halteleiste 9 begrenzt eine an der Innenseite des Seitenteils 5 ausgebildete Nut 10, in welche der zugehörige Befestigungsflansch 2 des Baugruppenträgers 1 eingreift. An der hinteren Kante des Seitenteils 5 ist ein Haltesteg 11 zur Befestigung der Rückwand 7 vorgesehen.

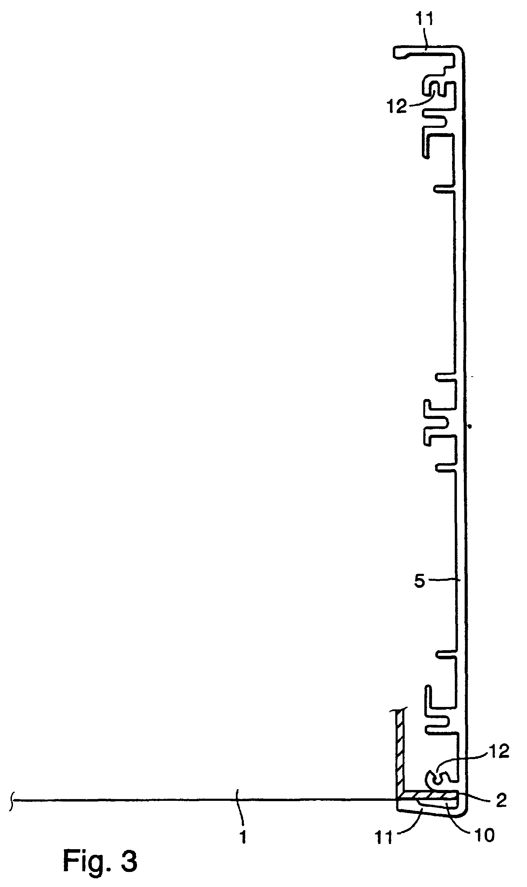

Gemäß Figur 3 haben die Seitenwände 2 im wesentlichen U-förmigen Grundriß. Dabei bildet der vordere U-Schenkel die Halteleiste 9 für den Befestigungsflansch 2 und der hintere U-Schenkel den Haltesteg 11 für die Rückwand 7. An der Innenseite des Seitenteils 5 sind ferner zwei Führungen 12 für die Gewindebolzen 8 vorgesehen.

Zur Montage werden die beiden Seitenteile 5 seitlich auf die Befestigungsflansche 2 des Baugruppenträgers 1 aufgeschoben. Dabei greifen die Befestigungsflansche 2 in die Nuten 10 ein. Anschließend kann die Rückwand 7 zwischen die Seitenteile 5 eingesetzt und an den zugehörigen Haltestegen 11 befestigt werden. Zum Schluß wird die Deckplatte 6 aufgelegt. Bodenplatte 4 und Deckplatte 6 weisen an ihren vier Ecken Bohrungen für die Gewindebolzen 8 auf.

Nach der Montage ist der Baugruppenträger 1 vollständig verkleidet, wie dies in Figur 2 zu sehen ist. Lediglich das Einbaufeld 3 bleibt zugänglich. Es ist ein formschönes Tischgerät entstanden, dem nicht mehr anzusehen ist, daß es im Kern aus einem genormten Industrie-Baugruppenträger besteht an den einige wenige Verkleidungsteile montiert wurden.

### Zusammenstellung der Bezugszeichen

- 1: Baugruppenträger
- 2: Befestigungsflansch (von 1)
- 3: Einbaufeld (von 1)
- 4: Bodenplatte
- 5: Seitenteile
- 6: Deckplatte
- 7: Rückwand
- 8: Gewindebolzen
- 9: Halteleiste (von 5)
- 10: Nut (an 5)
- 11: Haltesteg (an 5)
- 12: Führungen (an 5)

## Patentansprüche

1. Bauelementesatz zur Verkleidung eines Baugruppenträgers (1), der an seiner Frontseite seitlich überstehende Befestigungsflansche (2) aufweist, umfassend:
a) eine untersetzbare Bodenplatte (4), auf welcher der zu verkleidende Baugruppenträger (1) aufliegt;
b) zwei seitlich an dem Baugruppenträger (1) ansetzbare Seitenteile (5) mit an deren Vorderkanten nach innen abgewinkelten Halteleisten (9), welche die Befestigungsflansche (2) umgreifen;
c) eine auf den Baugruppenträger (1) und die beiden Seitenteile (5) aufsetzbare Deckplatte (6);
d) Befestigungsmittel, welche die Bodenplatte (4), die Seitenteile (5) und die Deckplatte (6) miteinander lösbar verbinden.

2. Bauelementesatz nach Anspruch 1, dadurch **gekennzeichnet,** daß er ferner umfaßt:
e) eine zwischen die Seitenteile (5) einsetzbare Rückwand (7).

3. Bauelementesatz nach Anspruch 1 oder 2, dadurch **gekennzeichnet,** daß an den Innenseiten der Seitenteile (5) Nuten (10) ausgebildet sind, in welche die Befestigungsflansche (2) des Baugruppenträgers (1) eingreifen.

4. Bauelementesatz nach Anspruch 2 oder 3, dadurch **gekennzeichnet,** daß die Seitenteile (5) im Bereich ihrer Hinterkanten Haltestege (11) für die Befestigung der Rückwand (7) aufweisen.

5. Bauelementesatz nach einem der Ansprüche 1 bis 4, dadurch **gekennzeichnet,** daß die Seitenwände (5) gleich ausgebildet sind und im wesentlichen U-förmigen Grundriß haben, wobei die vorderen U-Schenkel die Halteleisten (9) für die Befestigungsflansche (2) bilden und die hinteren U-Schenkel die Haltestege (11) für die Rückwand (7) darstellen.

6. Bauelementesatz nach einem der Ansprüche 1 bis 5, dadurch **gekennzeichnet,** daß die Seitenteile (5) als Strangpreßprofil ausgeführt sind.

7. Bauelementesatz nach einem der Ansprüche 1 bis 6, dadurch **gekennzeichnet,** daß die Bodenplatte (4) und die Deckplatte (6) als Kunststoff-Formteile ausgeführt sind.

8. Bauelementesatz nach einem der Ansprüche 1 bis 7, dadurch **gekennzeichnet,** daß die Befestigungsmittel Gewindebolzen (8) sind, welche durch die Seitenteile (5) hindurchgeführt sind.
